# EUROPEAN PATENT SPECIFICATION

(11) **EP 3 270 271 B1**
(45) Date of publication and mention of the grant of the patent: **25.11.2020**
(21) Application number: 16784374.7
(22) Date of filing: 06.02.2016
(51) Int. Cl.: G02F 1/1333, G06F 3/041, G06F 3/044, H01L 27/32, G06F 3/01, G06F 3/042

(54) **IN-CELL TOUCH SCREEN AND DISPLAY DEVICE**
ZELLINTEGRIERTER BERÜHRUNGSBILDSCHIRM UND ANZEIGEVORRICHTUNG
ÉCRAN TACTILE DANS UNE CELLULE ET DISPOSITIF D'AFFICHAGE

(30) Priority: 07.09.2015 CN 201510563831
(43) Date of publication of application: 17.01.2018
(73) Proprietor: BOE Technology Group Co., Ltd., Beijing 100015 (CN); Beijing BOE Optoelectronics Technology Co., Ltd., Beijing 100176 (CN)
(72) Inventor: HE, Quanhua, Beijing 100176 (CN); SHI, Lingyun, Beijing 100176 (CN); ZHANG, Hao, Beijing 100176 (CN); XIE, Xiaobo, Beijing 100176 (CN); WANG, Xiurong, Beijing 100176 (CN); XUE, Zijiao, Beijing 100176 (CN)
(74) Representative: AWA Sweden AB
(86) International application number: PCT/CN2016/073712
(87) International publication number: WO 2017/041431

(56) References cited:
- EP-A2- 2 735 946
- CN-A- 102 466 907
- CN-A- 102 902 387
- CN-A- 103 049 156
- CN-A- 103 218 097
- CN-A- 103 838 430
- CN-A- 104 216 578
- CN-A- 105 182 582
- CN-U- 204 189 153
- KR-A- 20130 003 215
- US-A1- 2010 144 391

## Description

### BACKGROUND OF THE INVENTION

### Field of the Invention

Embodiments of the present disclosure relate to a field of touch display technology, and more particularly, to an in-cell touch screen and a display device.

### Description of the Related Art

With a rapid development of display technology, a touch screen has been gradually widely used in people's life. Currently, the touch screen can be divided into according to the component and structure thereof: Add-On Mode Touch Screen, On-Cell Touch Screen and In-Cell Touch Screen. The add-on mode touch screen is generally a liquid crystal display screen with a touch function, which is formed by producing separately a touch screen and a liquid crystal display screen in different production lines and assembling them together. The add-on mode touch screen presents some shortcomings, such as a relatively higher manufacturing cost, a relatively lower light transmittance, and a relatively thicker module. The in-cell touch screen is generally formed by embedding touch electrodes of the touch screen within a liquid crystal display screen. In this way, it not only can reduce overall thickness of the module, but also can greatly reduce the manufacturing cost of the touch screen, therefore, such an in-cell touch screen is more and more significantly favored by major panel manufacturers.

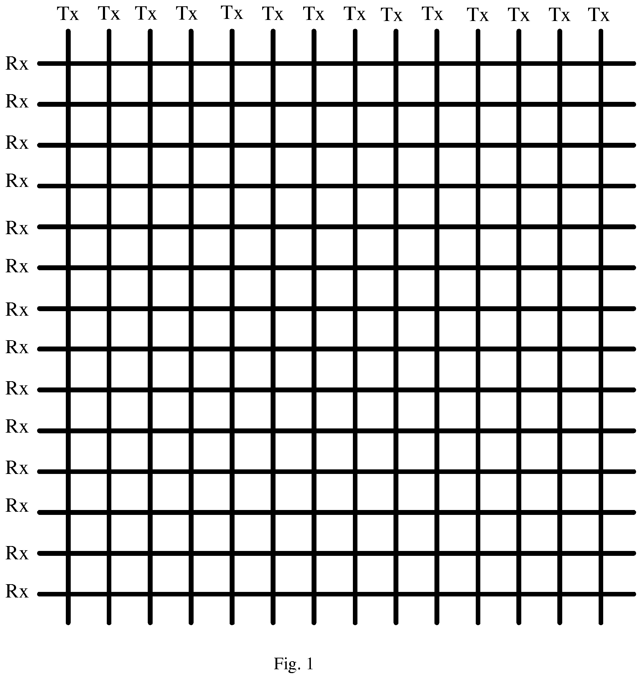

At present, a conventional capacitive in-cell touch screen is generally achieved by directly additionally arranging touch scanning lines and touch sensing lines on a conventional TFT (Thin Film Transistor) array substrate, i.e., manufacturing two layers of straight metal electrodes, which are located in different planes with projections thereof on the array substrate intersecting with each other, on a surface of the TFT array substrate, as shown in Fig. 1. Such two layers of metal electrodes are used as touch driving lines Tx and touch sensing lines Rx, respectively, and a mutual capacitance is formed at each intersection of the touch driving lines Tx and the touch sensing lines Rx in different planes. It works as follows: when the metal electrode used as the touch driving line Tx is loaded with a touch driving signal, a voltage signal obtained by a coupling of the mutual capacitance on the touch sensing lines Rx is detected, in this process, if there is a person's body being in contact with the touch screen, then an electric field from the body would make an effect on the mutual capacitance, and change the capacitance of the mutual capacitance, and further change the voltage signal obtained by coupling on the touch sensing lines Rx; thus, a touch position may be determined according to the change of the voltage signal.

However, in the above conventional capacitive in-cell touch screen, it is relatively small for the mutual capacitance generated between the touch sensing line and the touch driving line, thus the change of the mutual capacitance due to the effect of the electric field from the body on the capacitive in-cell touch screen is relatively small. In this case, when the body makes contact with the touch screen, the change of the voltage signal obtained by coupling on the touch sensing line is small, so that the sensitivity of the touch screen is very low.

EP 2 735 946 discloses an In-Cell touch panel and a touch display device. The In-Cell touch panel includes: a color filter substrate; a common electrode disposed on the color filter substrate; an array substrate disposed opposite the color filter substrate; an IC disposed on the array substrate; a plurality of data lines and a plurality of gate lines disposed perpendicular to the data lines are disposed on the array substrate; the common electrode is divided into a plurality of common electrode lines, where the common electrode lines also function as drive electrodes or sense electrodes, and the IC is a timesharing IC used for providing the In-Cell touch panel with display signals and touch drive signals and detecting the touch signals of the In-Cell touch panel.

CN 204 189 153 discloses a wiring structure with inductive layers, a touch screen and a touch device. The wiring structure comprises the first inductive layer and the second inductive layer which are formed on the two surfaces of a base plate respectively, wherein the first inductive layer comprises a plurality of first touch electrodes sequentially arranged in the first direction, each touch electrode comprises a rectangular electrode wire and a plurality of strip-shaped branches extending from the rectangular electrode wire towards the two sides in the first direction, and the strip-shaped branches between every two adjacent first touch electrodes are not overlapped; the second inductive layer comprises a plurality of second touch electrodes sequentially arranged in the second direction, the opposite sides of every two adjacent second touch electrodes are two complementary sawtooth-shaped electrode wires, every two adjacent second touch electrodes do not intersect, and the first direction and the second direction intersect. By means of the wiring structure with the inductive layers, the capacitive sensing area between the first touch electrodes and the second touch electrodes is enlarged, so that the sensitivity of the touch screen is improved.

### SUMMARY OF THE INVENTION

In order to at least partially overcome the above drawbacks and/or shortcomings in the above-described prior art, embodiments of the present disclosure provide an in-cell touch screen and a display device, so as to improve the sensitivity of the capacitive in-cell touch screen when being touched.

The embodiment of the present disclosure provides an in-cell touch screen, according to the subject-matter of claim 1.

According to an embodiment of the present disclosure, the in-cell touch screen further comprises a plurality of pixel units arranged in a matrix on the array substrate; wherein the first direction is a column direction or a row direction of the pixel units.

According to an embodiment of the present disclosure, in order to facilitate the implementation, the first direction is the column direction of the pixel units, in each of the second touch electrodes, two adjacent first sub-electrodes are located at two sides of a same column of pixel units, respectively, and two adjacent second sub-electrodes are located at two sides of a same row of pixel units, respectively; or
the first direction is the row direction of the pixel units, in each of the second touch electrodes, two adjacent first sub-electrodes are located at two sides of a same row of pixel units, respectively, and two adjacent second sub-electrodes are located at two sides of a same column of pixel units, respectively.

According to an embodiment of the present disclosure, in order to facilitate the implementation, the first direction is the column direction of the pixel units, two adjacent first sub-electrodes in a same second touch electrode are located at two sides of a same column of pixel units, respectively.

According to an embodiment of the present disclosure, in order to simplify the manufacturing process, the second touch electrodes are located on the side of the array substrate facing the opposite substrate; and
the first direction is the column direction of the pixel units, the second touch electrodes function as a data line of the associated column of pixel units in a display period.

According to an embodiment of the present disclosure, in order to ensure an aperture ratio, the in-cell touch screen further comprises a black matrix arranged on the side of the array substrate facing the opposite substrate or the side of the opposite substrate facing the array substrate; and
wherein an orthographic projection of the second touch electrode on the array substrate is located within an orthographic projection of the black matrix on the array substrate.

According to an embodiment of the present disclosure, the first touch electrode is a touch driving electrode, and the second touch electrode is a touch sensing electrode; or
the first touch electrode is a touch sensing electrode, and the second touch electrode is a touch driving electrode.

Correspondingly, the embodiment of the present disclosure also provides a display device, comprising any one of the above-described exemplary in-cell touch screens.

According to an embodiment of the present disclosure, the display device is a liquid crystal display or an organic electroluminescent display.

In the above-described exemplary in-cell touch screens and display devices, each of the second touch electrodes staggered with the first touch electrode is composed of first sub-electrodes and second sub-electrodes, which are sequentially connected with each other in the first direction in an alternate mode, and the first sub-electrodes extend in the first direction, the second sub-electrodes extend in a direction perpendicular to the first direction, and an orthographic projection of the second sub-electrode on the array substrate is located within an orthographic projection of the first touch electrode on the array substrate. Compared with conventional in-cell touch screen, the second touch electrode is made to be a sawtoothed line, it may increase the relative overlapping area between the first touch electrode and the second touch electrode, thereby increasing the mutual capacitance between the first touch electrode and the second touch electrode per unit area and improving the sensitivity of the in-cell touch screen when being touched. Furthermore, the first touch electrode is obtained by only changing the structure of the conventional common electrode layer, therefore, based on the conventional manufacturing processes, it is unnecessary to use additional manufacturing processes to separately manufacture the first touch electrode, thereby saving manufacturing cost and improving production efficiency.

### BRIEF DESCRIPTION OF THE DRAWINGS

Fig. 1 is a schematic structural view of a capacitive in-cell touch screen in the prior art;
Fig. 2 is a schematic structural view of a first capacitive in-cell touch screen according to an embodiment of the present disclosure;
Fig. 3 is a schematic structural view of a second capacitive in-cell touch screen according to an embodiment of the present disclosure;
Fig. 4 is a schematic structural view of a third capacitive in-cell touch screen according to an embodiment of the present disclosure;
Fig. 5a is a schematic structural view of a fourth capacitive in-cell touch screen according to an embodiment of the present disclosure;
Fig. 5b is a schematic structural view of a fifth capacitive in-cell touch screen according to an embodiment of the present disclosure;
Fig. 6a is a schematic structural view of a sixth capacitive in-cell touch screen according to an embodiment of the present disclosure;
Fig. 6b is a schematic structural view of a seventh capacitive in-cell touch screen according to an embodiment of the present disclosure;
Fig. 7 is a schematic structural view of an eighth capacitive in-cell touch screen according to an embodiment of the present disclosure.

### DETAILED DESCRIPTION OF PREFERRED EMBODIMENTS OF THE INVENTION

Detailed embodiments of the exemplary in-cell touch screen and the display device will be described in detail below, in conjunction with the accompanying drawings. In the specification, the same or similar reference number indicates the same or similar component. The following description of the embodiments of the present disclosure with reference to the accompanying drawings is intended to explain the general concept of the present disclosure, but should not be interpreted as limiting the present disclosure.

In addition, in the following detailed description, for the purpose of explanation, many specific details are set forth to provide a comprehensive understanding for the embodiments of the present disclosure. However, obviously, one or more embodiments may be implemented without theses specific details. In other cases, well-known structures and devices are embodied in an illustration manner to simplify the accompanying drawings.

In the drawings, the thickness and the shape of the film in each layer are not representative of the real proportion of the in-cell touch screen, instead, they only schematically illustrate the content of the present disclosure.

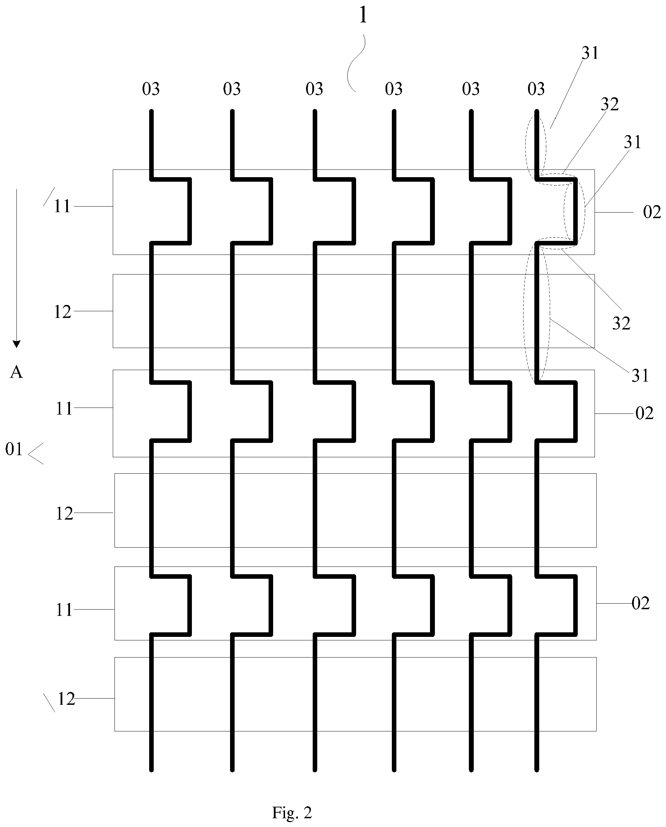

According to a general concept of the present disclosure, an embodiment of the present disclosure provides an in-cell touch screen, as shown in Figs. 2-7, comprising: an array substrate 1 and an opposite substrate (not shown in Figs. 2-7) arranged opposite to the array substrate 1; and a common electrode layer 01 located on a side of the opposite substrate facing the array substrate 1 or a side of the array substrate 1 facing the opposite substrate. The common electrode layer 01 is divided into first strip-shaped electrodes 11 and second strip-shaped electrodes 12, which are arranged alternately in a first direction A and spaced apart from each other, and in a touch period, the in-cell touch screen works as follows:

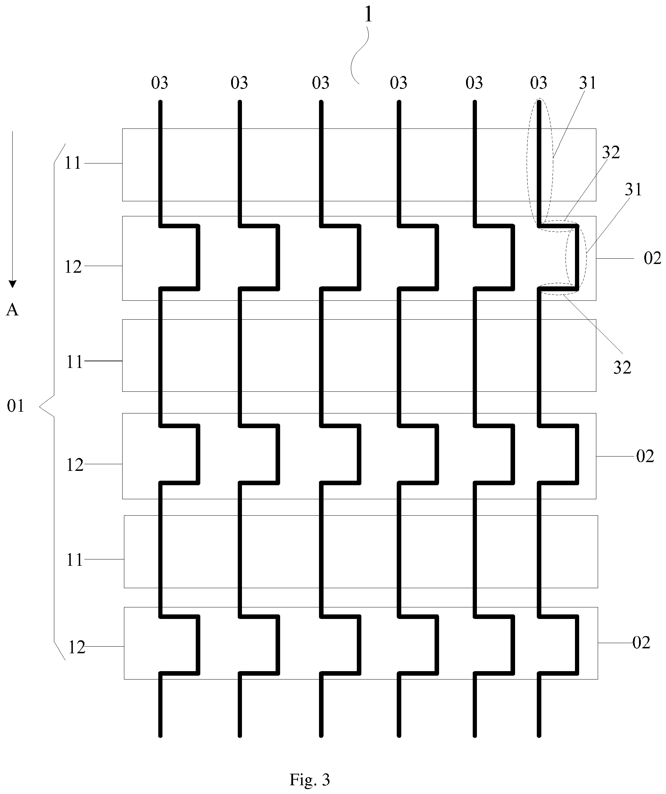

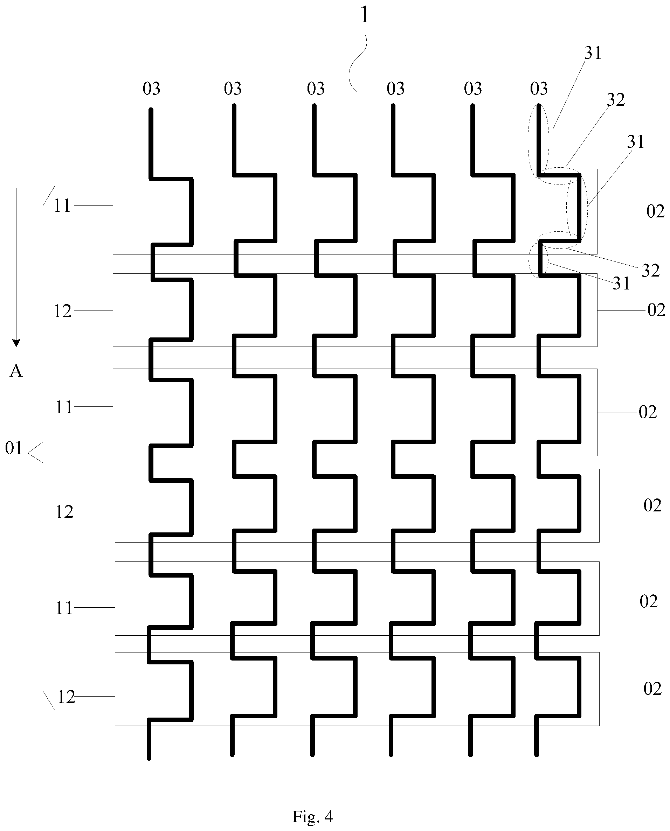

As shown in Fig. 2, the first strip-shaped electrodes 11 function as first touch electrodes 02; or as shown in Fig. 3, the second strip-shaped electrodes 12 function as first touch electrodes 02; or as shown in Fig. 4, the first strip-shaped electrodes 11 and the second strip-shaped electrodes 12 both function as first touch electrodes 02.

The in-cell touch screen further comprises a plurality of second touch electrodes 03, each of the second touch electrodes 03 comprises first sub-electrodes 31 and second sub-electrodes 32, which are sequentially connected with each other in the first direction A in an alternate and orthographic mode, and each of the second touch electrodes 03 is staggered with the first touch electrode 02.

The first sub-electrodes 31 extend in the first direction A, the second sub-electrodes 32 extend in a direction perpendicular to the first direction A, and an orthographic projection of the second sub-electrode 32 on the array substrate 1 is located within an orthographic projection of the corresponding first touch electrode 02 on the array substrate 1.

In the above-described exemplary in-cell touch screen, each of the second touch electrodes staggered with the first touch electrodes comprises first sub-electrodes and second sub-electrodes, which are sequentially connected with each other in the first direction in an alternate and orthographic mode, and the first sub-electrodes extend in the first direction, the second sub-electrodes extend in a direction perpendicular to the first direction, and an orthographic projection of the second sub-electrode on the array substrate is located within an orthographic projection of the corresponding first touch electrode on the array substrate. Compared with conventional in-cell touch screen, the second touch electrode is made to be a sawtoothed line, it may increase the relative overlapping area between the first touch electrode and the second touch electrode, thereby increasing the mutual capacitance between the first touch electrode and the second touch electrode per unit area and improving the sensitivity of the in-cell touch screen when being touched.

Furthermore, the first touch electrode in the above-described in-cell touch screen is obtained by only changing the structure of the conventional common electrode layer, therefore, based on the conventional manufacturing processes, it is unnecessary to use additional manufacturing processes to separately manufacture the first touch electrode, thereby saving manufacturing cost and improving production efficiency.

According to an embodiment of the present disclosure, in the above-described exemplary in-cell touch screen, the first touch electrode may function as a touch driving electrode, and the second touch electrode may function as a touch sensing electrode; or the first touch electrode may function as a touch sensing electrode, and the second touch electrode may function as s a touch driving electrode. They will not be limited in the present disclosure.

In the above-described exemplary in-cell touch screen, the touch driving electrode is driven in a time-sharing manner. In a display period, the strip-shaped electrode is configured to be loaded with a common electrode signal, and in a touch period, the strip-shaped electrode serving as the first touch electrode is configured to be loaded with a touch driving signal, and the second touch electrode is used to couple with a voltage signal of the touch driving signal and make an output; or in a touch period, the second touch electrode is configured to be loaded with a touch driving signal, and the strip-shaped electrode serving as the first touch electrode is used to couple with a voltage signal of the touch driving signal and make an output. As for the above-described in-cell touch screen, it is driven in the touch period and the display period in a time-sharing manner, thus, on the one hand, the chip for display driving and the chip for touch driving may be integrated together so that the manufacturing cost may be further reduced, on the other hand, the time-sharing driving may eliminate mutual interference between display operation and touch operation, thereby improving image quality and touch accuracy.

The above-described exemplary in-cell touch screen may be applied to a liquid crystal display screen or an organic electroluminescent display screen, for example. They will not be limited herein. It should be noted that, if the above-described exemplary in-cell touch screen is applied to an organic electroluminescent display screen, the common electrode layer generally refers to a cathode layer in the organic electroluminescent display screen, which is connected to each organic electroluminescent pixel. Alternatively, in some organic electroluminescent display screen, it is an anode layer to be connected to each organic electroluminescent pixel. They will not be limited herein.

If the above-described exemplary in-cell touch screen is applied to the liquid crystal display screen, then it may be applied to a Twisted Nematic (TN) liquid crystal display screen, or an Advanced Dimension Switch (ADS) liquid crystal display screen, or a High-Advanced Dimension Switch (HADS) liquid crystal display screen, or an In-Plane Switch (IPS) liquid crystal display screen.

According to an embodiment of the present disclosure, in the above-described exemplary in-cell touch screen, the material of the second touch electrodes may be chosen from metal material or transparent conductive material, which is not limited herein. If the metal material is chosen to be as the material for producing the second touch electrodes, then it can effectively reduce the resistance of the second touch electrodes, thereby reducing signal-to-noise ratio for the signal to be transferred.

Furthermore, the above-described exemplary touch screen is driven in the touch period and the display period in a time-sharing manner, therefore, on the one hand, the chip for display driving and the chip for touch driving may be integrated together so that the manufacturing cost may be further reduced, on the other hand, the time-sharing driving may eliminate mutual interference between display operation and touch operation, thereby improving image quality and touch accuracy.

As an example, in the above-described in-cell touch screen, the second touch electrodes may be arranged on the side of the array substrate facing the opposite substrate, i.e., the second touch electrodes are arranged on the array substrate. Alternatively, the second touch electrodes may be arranged on the side of the opposite substrate facing the array substrate, i.e., the second touch electrodes are arranged on the opposite substrate. They will not be limited herein.

According to an embodiment of the present disclosure, the array substrate is generally further provided with pixel units arranged in a matrix, and various strip-shaped electrodes formed from the common electrode layer generally extend in a column direction of the pixel units in the array substrate, that is, the first direction A is a row direction of the pixel units, or, various strip-shaped electrodes formed from the common electrode layer generally extend in a row direction of the pixel units in the array substrate, that is, the first direction A is a column direction of the pixel units. Obviously, the various strip-shaped electrodes may extend in any other direction, which is not limited herein.

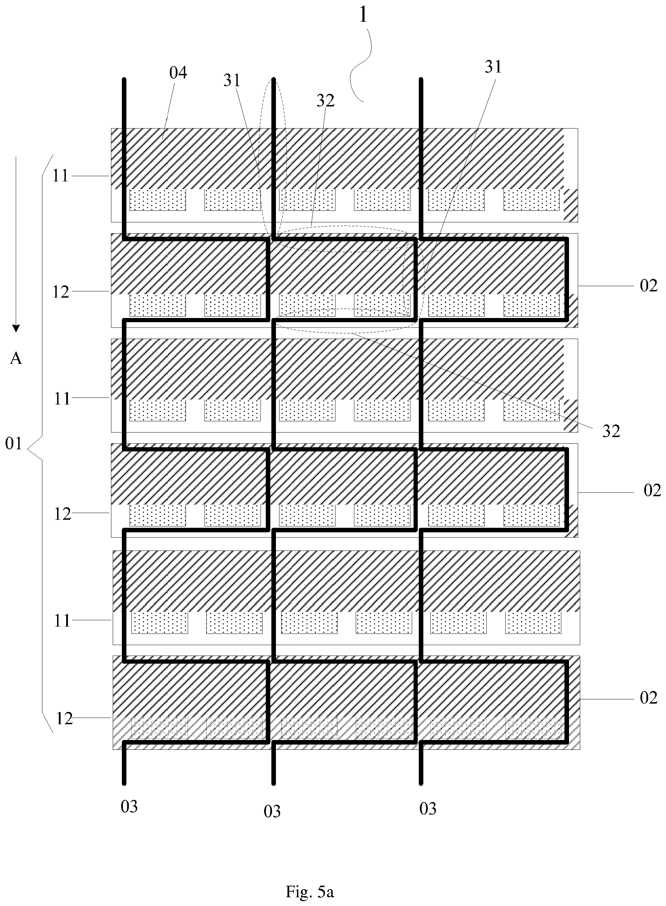

According to an embodiment of the present disclosure, in the above-described in-cell touch screen, as shown in Figs. 5a-6b, it further includes a plurality of pixel units 04 arranged in a matrix on the array substrate 1.

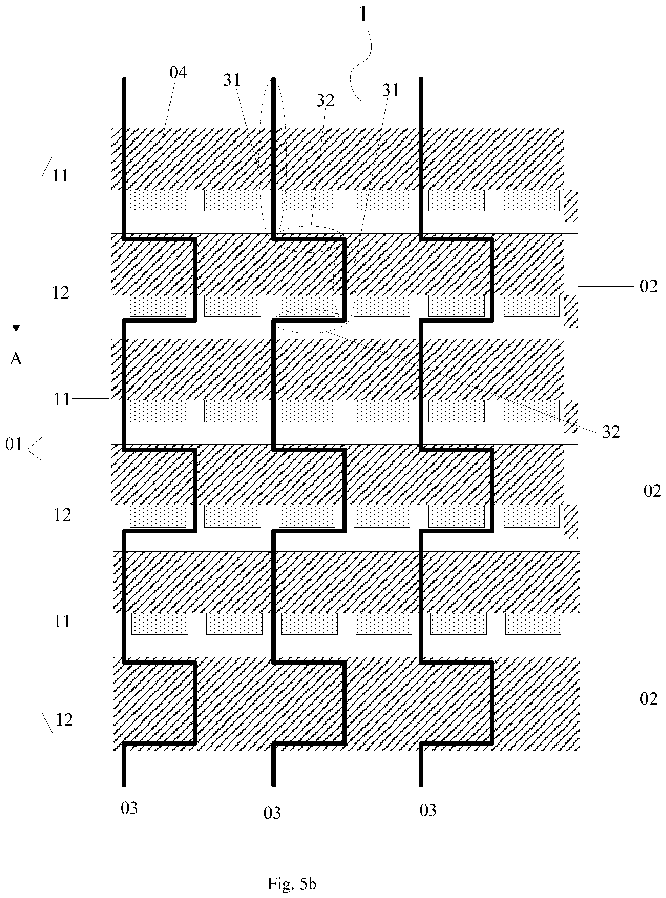

As shown in Figs. 5a and 5b, the first direction A is a column direction of the pixel units 04.

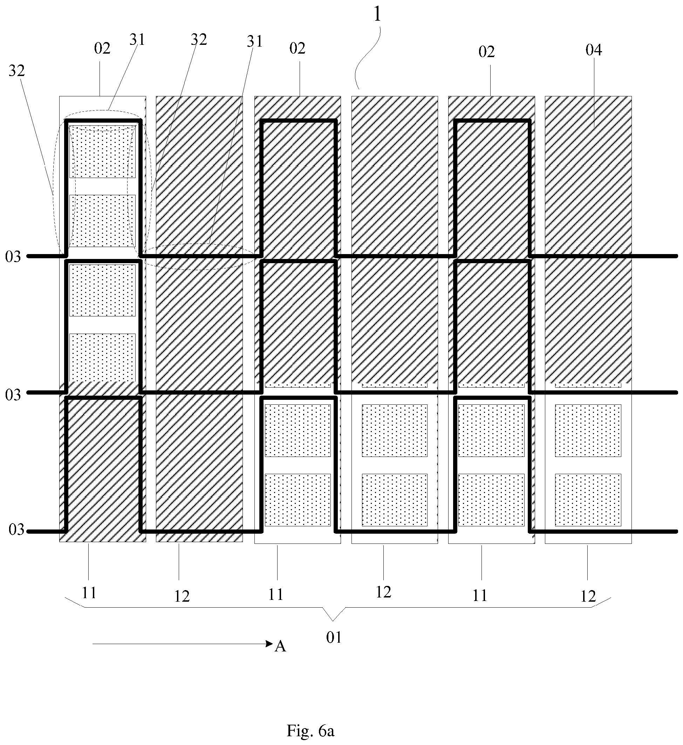

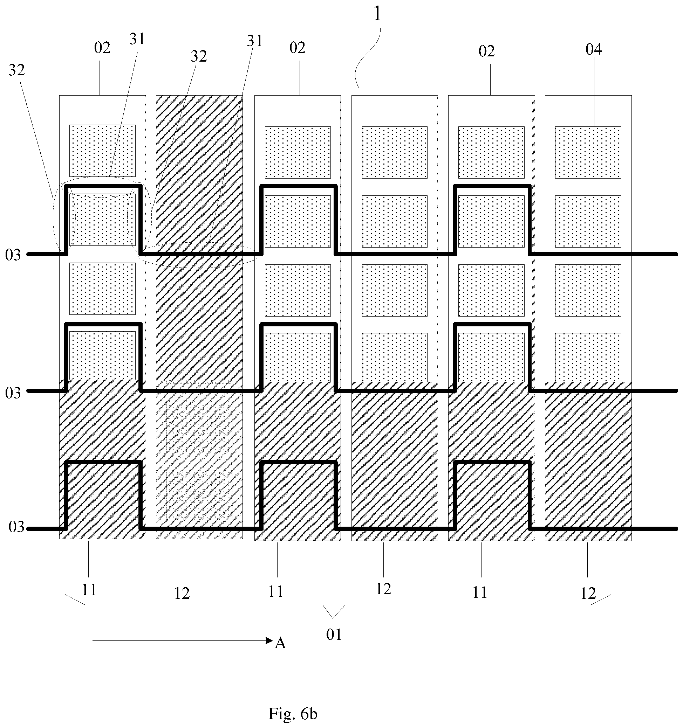

Alternatively, as shown in Figs. 6a and 6b, the first direction A is a row direction of the pixel units 04.

In a specific example, in order not to affect the normal display function, a dividing line is generally configured to keep away from an opening area for display when dividing the common electrode layer. Therefore, in the above-described in-cell touch screen according to the embodiment of the present disclosure, if the first direction is the column direction of the pixel units, then the common electrode layer may be divided at the area corresponding to a gap between adjacent rows of pixel units; if the first direction is the row direction of the pixel units, then the common electrode layer may be divided at the area corresponding to a gap between adjacent columns of pixel units. That is to say, an orthographic projection of a gap between various strip-shaped electrodes on the array substrate is generally located within the gap between pixel units.

As an example, in the above-described in-cell touch screen, as shown in Figs. 5a and 5b, if the first direction A is the column direction of the pixel units 04, then in each of the second touch electrodes 03, two adjacent first sub-electrodes 31 are located at two sides of the same column of pixel units 04, respectively, and two adjacent second sub-electrodes 32 are located at two sides of the same row of pixel units 04, respectively. The greater the distance between two adjacent first sub-electrodes 31 is, i.e., the greater the length of the second sub-electrode 32 is, the greater the relative overlapping area between the first touch electrode 02 and the second touch electrode 03 is. However, if the distance between two adjacent first sub-electrodes 31 is relatively large, it will adversely affect the wiring of the second sub-electrodes 32 in two adjacent second touch electrodes 03.

Alternatively, as shown in Figs. 6a and 6b, if the first direction A is the row direction of the pixel units 04, then in each of the second touch electrodes 03, two adjacent first sub-electrodes 31 are located at two sides of the same row of pixel units 04, respectively, and two adjacent second sub-electrodes 32 are located at two sides of the same column of pixel units 04, respectively. The greater the distance between two adjacent first sub-electrodes, i.e., the greater the length of the second sub-electrode 32 is, the greater the relative overlapping area between the first touch electrode 02 and the second touch electrode 03 is. However, if the distance between two adjacent first sub-electrodes 31 is relatively large, it will adversely affect the wiring of the second sub-electrodes 32 in two adjacent second touch electrodes 03.

As an example, in the above-described in-cell touch screen, as shown in Fig. 5b, if the first direction A is the column direction of the pixel units 04, then two adjacent first sub-electrodes 31 in the same second touch electrode 03 are located at two sides of the same column of pixel units 04, respectively, that is, each second touch electrode 03 is associated with the same column of pixel units 04.

Alternatively, as shown in Fig. 6b, if the first direction A is the row direction of the pixel units 04, then two adjacent first sub-electrodes 31 in the same second touch electrode 03 are located at two sides of the same row of pixel units 04, respectively, that is, each second touch electrode 03 is associated with the same row of pixel units 04.

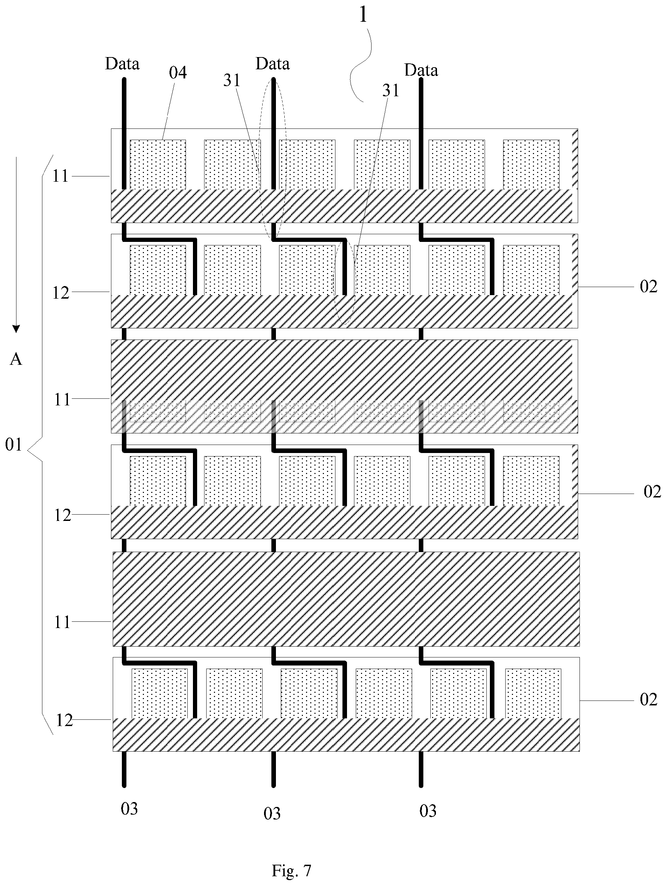

According to an embodiment of the present disclosure, in the above-described in-cell touch screen, as shown in Fig. 7, if the second touch electrodes 03 are arranged on the side of the array substrate 1 facing the opposite substrate, then the second touch electrodes 03 function as data lines of the associated column of pixel units 04 during a display period, for providing the associated columns of pixel units 04 with data signals during the display period. At least the data line connected to the column of pixel units 04 associated with the second touch electrode is configured to have a shape corresponding to the second touch electrode, and the data line is used as actual data line in the display period, and as the second touch electrode in the touch period. In this way, it is unnecessary to use additional manufacturing processes to separately manufacture the second touch electrode, based on the conventional manufacturing processes, thereby saving manufacturing cost and improving production efficiency.

The density and the width of the touch driving electrode and the touch sensing electrode may be chosen according to the required touch accuracy. As an example, the accuracy of the touch screen is typically at the level of millimeter, therefore, for example, the optimized width of the touch driving electrode and the touch sensing electrode is set to be as 5-7mm. On the other hand, the accuracy of the display screen is generally at the level of micrometer, therefore, one first touch electrode generally covers many rows or columns of pixel units, and one second touch electrode is generally arranged by an interval of many columns or rows of pixel units. The accuracy in the embodiment of the present disclosure refers to the size of a touch unit in the touch screen or a pixel unit of the display screen.

According to an embodiment of the present disclosure, in the above-described in-cell touch screen, it further comprises a black matrix arranged on the side of the array substrate facing the opposite substrate or the side of the opposite substrate facing the array substrate; and
wherein an orthographic projection of the second touch electrode on the array substrate is located within an orthographic projection of the black matrix on the array substrate. Thus, the second touch electrode is arranged within the black matrix, thereby it avoids the second touch electrode from affecting the aperture ratio of the display screen.

Based on the same general concept of the present disclosure, the embodiment of the present disclosure also provides a display device, comprising the above-described in-cell touch screen. The display device may be a mobile phone, a tablet computer, a television, a monitor, a notebook computer, a digital picture frame, a navigator and any other products or components having a display function. The implementation mode of the display device may make reference to the above embodiments of the in-cell touch screen, which will not be repeated herein.

As an example, the display device is for example a liquid crystal display or an organic electroluminescent display, which will not be limited herein.

In the above-described exemplary in-cell touch screens and display devices, each of the second touch electrodes staggered with the first touch electrode is composed of first sub-electrodes and second sub-electrodes, which are sequentially connected with each other in the first direction in an alternate and orthogonal mode, and the first sub-electrodes extend in the first direction, the second sub-electrodes extend in a direction perpendicular to the first direction, and an orthographic projection of the second sub-electrode on the array substrate is located within an orthographic projection of the first touch electrode on the array substrate. Compared with conventional in-cell touch screen, the second touch electrode is made to be a sawtoothed line, it may increase the relative overlapping area between the first touch electrode and the second touch electrode, thereby increasing the mutual capacitance between the first touch electrode and the second touch electrode per unit area and improving the sensitivity of the in-cell touch screen when being touched. Furthermore, the first touch electrode is obtained by only changing the structure of the conventional common electrode layer, therefore, based on the conventional manufacturing processes, it is unnecessary to use additional manufacturing processes to separately manufacture the first touch electrode, thereby saving manufacturing cost and improving production efficiency.

## Claims

1. An in-cell touch screen, comprising:
an array substrate (1) and an opposite substrate arranged opposite to the array substrate (1);
a common electrode (01) located on a side of the opposite substrate facing the array substrate (1) or a side of the array substrate (1) facing the opposite substrate;
a plurality of second touch electrodes; and
a plurality of pixel units (04) arranged in a matrix on the array substrate (1),
wherein the common electrode (01) comprises a first strip-shaped electrode (11) and a second strip-shaped electrode (12), which are arranged alternately in a first direction (A) and spaced apart from each other, and in a touch period, at least one of the first strip-shaped electrode (11) and the second strip-shaped electrode (12) forms a first touch electrode (02), and an orthographic projection of a gap between the first strip-shaped electrode (11) and the second strip-shaped electrode (12) on the array substrate (1) is located within a gap between the pixel units (04);
wherein each of the second touch electrodes (03) comprises first sub-electrodes (31) and second sub-electrodes (32), which are sequentially connected with each other in the first direction (A) in an alternate mode and are perpendicular to each other, and each of the second touch electrodes (03) being intersected with the first touch electrode (02);
wherein the first sub-electrodes (31) extend in the first direction (A), the second sub-electrodes (32) extend in a direction perpendicular to the first direction (A), and an orthographic projection of each of the second sub-electrodes (32) on the array substrate (1) is located within an orthographic projection of the corresponding first touch electrode (02) on the array substrate (1); and
wherein the first direction (A) is a column direction or a row direction of the pixel units (04).

2. The in-cell touch screen according to claim 1, wherein,
the first direction (A) is the column direction of the pixel units (04), in each of the second touch electrodes (03), two adjacent first sub-electrodes (31) are located at two sides of a same column of pixel units (04), respectively, and two adjacent second sub-electrodes (32) are located at two sides of a same row of pixel units (04), respectively; or
the first direction (A) is the row direction of the pixel units (04), in each of the second touch electrodes (03), two adjacent first sub-electrodes (31) are located at two sides of a same row of pixel units (04), respectively, and two adjacent second sub-electrodes (32) are located at two sides of a same column of pixel units (04), respectively.

3. The in-cell touch screen according to claim 2, wherein, the first direction (A) is the column direction of the pixel units (04), two adjacent first sub-electrodes (31) in a same second touch electrode (03) are located at two sides of a same column of pixel units (04), respectively.

4. The in-cell touch screen according to claim 3, wherein the second touch electrodes (03) are located on the side of the array substrate (1) facing the opposite substrate; and
the first direction (A) is the column direction of the pixel units (04), the second touch electrodes (03) function as a data line of the associated column of pixel units (04) in a display period.

5. The in-cell touch screen according to any one of claims 1-4, further comprising a black matrix arranged on the side of the array substrate (1) facing the opposite substrate or the side of the opposite substrate facing the array substrate (1); and
wherein an orthographic projection of the second touch electrode (03) on the array substrate (1) is located within an orthographic projection of the black matrix on the array substrate (1).

6. The in-cell touch screen according to any one of claims 1-4, wherein one of the first touch electrode (02) and the second touch electrode (03) is a touch driving electrode, and the other is a touch sensing electrode.

7. A display device, comprising the in-cell touch screen according to any one of claims 1-6.

8. The display device according to claim 7, wherein the display device is a liquid crystal display or an organic electroluminescent display.

## Patentansprüche

1. Zellintegrierter Berührungsbildschirm, aufweisend:
ein Arraysubstrat (1) und ein gegenüberliegendes Substrat, das gegenüber dem Arraysubstrat (1) angeordnet ist;
eine gemeinsame Elektrode (01), die auf einer Seite des gegenüberliegenden Substrats, die dem Arraysubstrat (1) zugewandt ist, oder auf einer Seite des Arraysubstrats (1), die dem gegenüberliegenden Substrat zugewandt ist, angeordnet ist;
mehrere zweiten Berührungselektroden; und
mehrere Pixeleinheiten (04), die in einer Matrix auf dem Arraysubstrat (1) angeordnet sind,
wobei die gemeinsame Elektrode (01) eine erste streifenförmige Elektrode (11) und eine zweite streifenförmige Elektrode (12) aufweist, die abwechselnd in einer ersten Richtung (A) und mit Abstand voneinander angeordnet sind, und in einer Berührungsperiode mindestens eine der ersten streifenförmigen Elektrode (11) und der zweiten streifenförmigen Elektrode (12) eine erste Berührungselektrode (02) bildet, und eine orthographische Projektion eines Spalts zwischen der ersten streifenförmigen Elektrode (11) und der zweiten streifenförmigen Elektrode (12) auf dem Arraysubstrat (1) innerhalb eines Spalts zwischen den Pixeleinheiten (04) angeordnet ist;
wobei jede der zweiten Berührungselektroden (03) erste Unterelektroden (31) und zweite Unterelektroden (32) aufweist, die nacheinander in der ersten Richtung (A) in einem abwechselnden Modus miteinander verbunden sind und senkrecht zueinander stehen, und wobei jede der zweiten Berührungselektroden (03) mit der ersten Berührungselektrode (02) geschnitten wird;
wobei die ersten Unterelektroden (31) sich in der ersten Richtung (A) erstrecken, die zweiten Unterelektroden (32) sich in einer Richtung senkrecht zu der ersten Richtung (A) erstrecken und eine orthographische Projektion jeder der zweiten Unterelektroden (32) auf dem Arraysubstrat (1) innerhalb einer orthographischen Projektion der entsprechenden ersten Berührungselektrode (02) auf dem Arraysubstrat (1) angeordnet ist; und
wobei die erste Richtung (A) eine Spaltenrichtung oder eine Zeilenrichtung der Pixeleinheiten (04) ist.

2. Zellintegrierter Berührungsbildschirm nach Anspruch 1, wobei,
die erste Richtung (A) die Spaltenrichtung der Pixeleinheiten (04) ist, in jeder der zweiten Berührungselektroden (03) zwei benachbarte erste Unterelektroden (31) jeweils an zwei Seiten derselben Spalte von Pixeleinheiten (04) angeordnet sind und zwei benachbarte zweite Unterelektroden (32) jeweils an zwei Seiten derselben Zeile von Pixeleinheiten (04) angeordnet sind; oder
die erste Richtung (A) die Zeilenrichtung der Pixeleinheiten (04) ist, in jeder der zweiten Berührungselektroden (03) zwei benachbarte erste Unterelektroden (31) jeweils an zwei Seiten einer gleichen Zeile von Pixeleinheiten (04) angeordnet sind und zwei benachbarte zweite Unterelektroden (32) jeweils an zwei Seiten einer gleichen Spalte von Pixeleinheiten (04) angeordnet sind.

3. Zellintegrierter Berührungsbildschirm nach Anspruch 2, wobei die erste Richtung (A) die Spaltenrichtung der Pixeleinheiten (04) ist und zwei benachbarte erste Unterelektroden (31) in derselben zweiten Berührungselektrode (03) jeweils an zwei Seiten derselben Spalte von Pixeleinheiten (04) angeordnet sind.

4. Zellintegrierter Berührungsbildschirm nach Anspruch 3, wobei die zweiten Berührungselektroden (03) auf der Seite des Arraysubstrats (1) angeordnet sind, die dem gegenüberliegenden Substrat zugewandt ist; und
die erste Richtung (A) die Spaltenrichtung der Pixeleinheiten (04) ist, die zweiten Berührungselektroden (03) als eine Datenleitung der zugehörigen Spalte von Pixeleinheiten (04) in einer Anzeigeperiode arbeiten.

5. Zellintegrierter Berührungsbildschirm nach einem der Ansprüche 1-4, der ferner eine schwarze Matrix aufweist, die auf der Seite des Arraysubstrats (1), die dem gegenüberliegenden Substrat zugewandt ist, oder auf der Seite des gegenüberliegenden Substrats, die dem Arraysubstrat (1) zugewandt ist, angeordnet ist; und
wobei eine orthographische Projektion der zweiten Berührungselektrode (03) auf dem Arraysubstrat (1) innerhalb einer orthographischen Projektion der schwarzen Matrix auf dem Arraysubstrat (1) angeordnet ist.

6. Zellintegrierter Berührungsbildschirm nach einem der Ansprüche 1-4, wobei eine der ersten Berührungselektrode (02) und der zweiten Berührungselektrode (03) eine Berührungsantriebselektrode und die andere eine Berührungssensorelektrode ist.

7. Anzeigevorrichtung, den zellintegrierten Berührungsbildschirm nach einem der Ansprüche 1-6 aufweisend.

8. Anzeigevorrichtung nach Anspruch 7, wobei die Anzeigevorrichtung eine Flüssigkristallanzeige oder eine organische Elektrolumineszenzanzeige ist.

## Revendications

1. Écran tactile dans une cellule, comprenant :
un substrat matriciel (1) et un substrat opposé disposé à l'opposé du substrat matriciel (1) ;
une électrode commune (01) située sur un côté du substrat opposé tourné vers le substrat matriciel (1) ou un côté du substrat matriciel (1) tourné vers le substrat opposé ;
une pluralité de secondes électrodes tactiles ; et
une pluralité d'unités de pixels (04) disposées dans une matrice sur le substrat matriciel (1),
l'électrode commune (01) comprenant une première électrode en forme de bande (11) et une seconde électrode en forme de bande (12) qui sont disposées alternativement dans un premier sens (A) et espacées l'une de l'autre et, dans une période tactile, au moins une parmi la première électrode en forme de bande (11) et la seconde électrode en forme de bande (12) forme une première électrode tactile (02), et une projection orthographique d'un intervalle entre la première électrode en forme de bande (11) et la seconde électrode en forme de bande (12) sur le substrat matriciel (1) est située dans un intervalle entre les unités de pixels (04) ;
chacune des secondes électrodes tactiles (03) comprenant des premières sous-électrodes (31) et des secondes sous-électrodes (32) séquentiellement connectées les unes aux autres dans le premier sens (A) en mode alternatif et étant perpendiculaires les unes aux autres, chacune des secondes électrodes tactiles (03) croisant la première électrode tactile (02) ;
les premières sous-électrodes (31) s'étendant dans le premier sens (A), les secondes sous-électrodes (32) s'étendant dans un sens perpendiculaire au premier sens (A), et une projection orthographique de chacune des secondes sous-électrodes (32) sur le substrat matriciel (1) se situant dans une projection orthographique de la première électrode tactile correspondante (02) sur le substrat matriciel (1) ; et
le premier sens (A) étant un sens de colonnes ou un sens de rangées d'unités de pixels (04).

2. Écran tactile dans une cellule selon la revendication 1, dans lequel
le premier sens (A) est le sens de colonnes des unités de pixels (04) dans chacune des secondes électrodes tactiles (03), deux premières sous-électrodes adjacentes (31) se situent des deux côtés d'une même colonne d'unités de pixels (04) respectivement, et deux secondes sous-électrodes adjacentes (32) se situent des deux côtés d'une même rangée d'unités de pixels (04) respectivement ; ou
le premier sens (A) est le sens de rangées des unités de pixels (04) dans chacune des secondes électrodes tactiles (03), deux premières sous-électrodes adjacentes (31) se situent du même côté d'une même rangée d'unités de pixels respectivement (04) et deux secondes sous-électrodes adjacentes (32) se situent des deux côtés d'une même colonne d'unités de pixels (04) respectivement.

3. Écran tactile dans une cellule selon la revendication 2, dans lequel le premier sens (A) est le sens de colonnes des unités de pixels (04), deux première sous-électrodes adjacentes (31) dans une seconde électrode tactile (03) se situent des deux côtés d'une même colonne d'unités de pixels (04) respectivement.

4. Écran tactile dans une cellule selon la revendication 3, dans lequel les secondes électrodes tactiles (03) se situent sur le côté du substrat matriciel (1) tourné vers le substrat opposé ; et
le premier sens (A) est le sens de colonnes des unités de pixels (04), les secondes électrodes tactiles (03) office de ligne de données de la colonne associée d'unités de pixels (04) dans une période d'affichage.

5. Écran tactile dans une cellule selon l'une quelconque des revendications 1 à 4, comprenant en outre une matrice noire disposé sur le côté du substrat matriciel (1) tourné vers le substrat opposé ou le côté du substrat matriciel tourné vers le substrat matriciel (1) ; et
une projection orthographique de la seconde électrode tactile (03) sur le substrat matriciel (1) étant située dans une projection orthographique de la matrice noire sur le substrat matriciel (1).

6. Écran tactile dans une cellule selon l'une quelconque des revendications 1 à 4, dans lequel une parmi la première électrode tactile (02) et la seconde électrode tactile (03) est une électrode d'entraînement tactile, et l'autre est une électrode de détection tactile.

7. Dispositif d'affichage, comprenant l'écran tactile dans une cellule selon l'une quelconque des revendications 1 à 6.

8. Dispositif d'affichage selon la revendication 7, le dispositif d'affichage étant un écran à cristaux liquides ou un écran électroluminescent organique.
